# FASCICULE DE BREVET EUROPEEN

(11) **EP 0 467 803 B1**
(45) Date de publication et mention de la délivrance du brevet: **04.10.1995**
(21) Numéro de dépôt: 91420248.6
(22) Date de dépôt: 12.07.1991
(51) Int. Cl.: H01L 29/868

(54) **Diode pin à faible surtension initiale**
Pindiode mit niedriger Anfangsüberspannung
Pin-diode having a low initial overvoltage

(30) Priorité: 16.07.1990 FR 9009342
(43) Date de publication de la demande: 22.01.1992
(73) Titulaire: SGS-THOMSON MICROELECTRONICS S.A., 94250 Gentilly (FR)
(72) Inventeur: Pezzani, Robert, F-37210 Vouvray (FR)
(74) Mandataire: de Beaumont, Michel

(56) Documents cités:
- DE-A- 3 411 878
- FR-A- 2 412 946

## Description

La présente invention concerne le domaine des diodes PIN qui sont des diodes destinées à laisser passer le courant appliqué selon une première polarité et à bloquer des courants appliqués selon la polarité inverse.

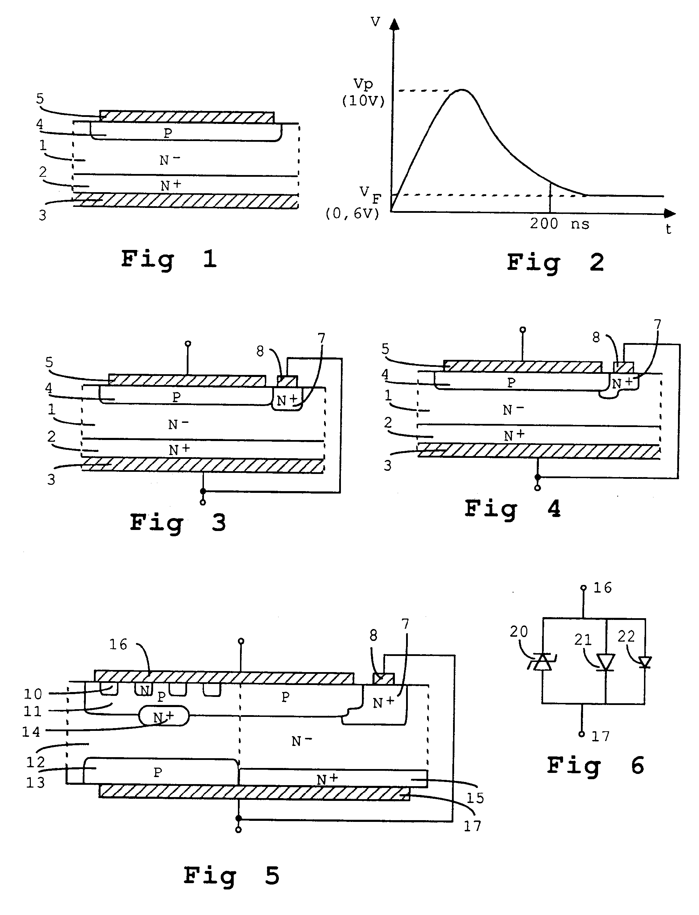

La figure 1 représente très schématiquement l'allure générale d'une diode PIN. Celle-ci comprend un substrat 1 faiblement dopé, le niveau de dopage étant couramment désigné par le symbole N⁻ ou par le symbole I pour indiquer que le dopage est proche du niveau intrinsèque, par exemple 5.10¹⁴ atomes par cm³. La face arrière du substrat 1 comprend une couche N⁺ d'un niveau de dopage élevé, par exemple 10²¹ atomes par cm³. Cette face est revêtue d'une métallisation de cathode 3. Dans la face avant est formée une région 4 de type P sur laquelle est formée une métallisation d'anode 5.

Normalement, une telle diode, quand elle conduit du courant, présente une chute de tension à ses bornes de l'ordre de 0,6 à 0,7 volt. Toutefois, si une tension est brutalement appliquée en sens direct aux bornes de la diode, il apparaît un pic de surtension initiale (peak on) associé à la durée d'installation des charges dans la zone intrinsèque.

La figure 2 illustre une courbe de tension en fonction du temps quand une tension directe est brutalement appliquée aux bornes de la diode. On voit que, dans une intervalle de l'ordre de 200 ns, on peut avoir une surtension initiale Vₚ de l'ordre de quelques dizaines de volts avant de redescendre à la chute de tension directe normale V_{F} de la diode.

Ce phénomène de retard à la mise en conduction de la diode peut être particulièrement gênant, par exemple quand une telle diode est associée en parallèle avec un composant de protection tel qu'un thyristor à déclenchement par avalanche par suite de l'apparition d'une surtension à ses bornes.

Ainsi, un objet de la présente invention est de prévoir une structure de diode PIN évitant le phénomène susmentionné de surtension initiale.

Pour atteindre cet objet, la présente invention prévoit une diode PIN à faible surtension à la mise en conduction comprenant une région d'anode de type P formée sur une première face d'un substrat de type N faiblement dopé, une région de cathode formée sur la deuxième face du substrat, et, sur une partie de la première face, une région supplémentaire de type N⁺ en contact avec la région d'anode pour former une jonction avec celle-ci, cette région supplémentaire étant connectée à la région de cathode.

Dans une application, cette diode est assemblée en une structure monolithique de façon tête-bêche avec un thyristor à déclenchement par avalanche.

Ces objets, caractéristiques et avantages ainsi que d'autres de la présente invention seront exposés plus en détail dans la description suivante de modes de réalisation particuliers faite en relation avec les figures jointes parmi lesquelles :
la figure 1 représente, en coupe, l'allure classique d'une diode PIN ;
la figure 2 représente la tension en fonction du temps aux bornes d'une diode PIN à la mise en conduction ;
les figures 3 et 4 représentent des vues en coupe de diodes PIN selon la présente invention ;
la figure 5 représente une vue en coupe de la combinaison monolithique d'un dispositif de déclenchement et d'une diode PIN selon la présente invention ; et
la figure 6 représente le circuit équivalent de la structure de la figure 5.

Conformément à l'usage dans le domaine de la représentation des composants semiconducteurs, les épaisseurs et les étendues latérales des diverses couches ne sont pas illustrées à l'échelle dans les vues en coupe des figures 1, 3, 4 et 5. Certaines dimensions ont été arbitrairement dilatées pour faciliter la lisibilité et/ou le tracé de ces figures. L'homme de l'art pourra se référer aux exemples numériques donnés dans la présente demande et aux dimensions usuelles dans la technique.

La figure 3 représente un premier mode de réalisation de la présente invention. En plus des couches et métallisations 1 à 5 déjà illustrées en figure 1, le dispositif de la figure 3 comprend, du côté de la surface supérieure de la diode PIN une région diffusée 7 de type N fortement dopée formant une jonction avec une partie de la région 4 de type P. Une métallisation 8 est solidaire de la surface supérieure de la région 7. Cette métallisation 8 est connectée à la métallisation d'anode de la diode.

La figure 4 représente une variante de réalisation de la présente invention. La couche 7 de type N⁺ est représentée comme situé partiellement sous la région 4. Cela résulte d'étapes successives de masquage et de dopage, la région 7 étant formée d'abord et la région 4 ensuite.

Grâce à la présente invention, dès qu'une tension est appliquée entre les bornes d'anode et de cathode de la diode, la jonction PN⁺ 4-7 conduit immédiatement et impose une tension basse aux bornes de dispositif. Toutefois, cette jonction de faible étendue ne peut laisser passer un courant important et dès que des porteurs en nombre suffisant ont été injectés dans le substrat 1, la diode verticale PN⁻N⁺ 4-1-2 prend le relais et le dispositif fonctionne comme une diode PIN classique dans laquelle on a évité le phénomène de surtension à l'origine.

L'une des applications d'une telle diode est d'être disposée en anti-parallèle avec un thyristor sans gâchette à déclenchement par avalanche, cet ensemble étant disposé en série avec un ensemble de même type polarisé en sens inverse pour assurer une protection contre des surtensions positives ou négatives.

L'association en parallèle d'un thyristor à déclenchement par retournement avec une diode est connue en elle-même, l'invention résidant dans la modification de la diode. Ainsi, la figure 5 représente dans sa partie gauche un thyristor comprenant une couche supérieure 10 de type N à courts-circuits d'émetteur, une couche 11 de type P, un substrat 12 de type N⁻ et une couche inférieure 13 de type P. Une région 14 de type N⁺ est souvent prévue au niveau d'une partie de l'interface entre les couches 11 et 12 pour fixer la tension de retournement du thyristor. La partie droite de la figure représente une diode PIN constituée à partir de la couche P 11, du substrat 12 et d'une couche inférieure 15 de type N⁺. Une métallisation supérieure 16 relie l'anode de la diode à la cathode du thyristor et une métallisation inférieure 17 relie la cathode de la diode à l'anode du thyristor. En outre, on retrouve dans la partie droite de la figure la région N⁺ 7 selon l'invention avec sa métallisation 8 qui est reliée à la métallisation 17.

La figure 6 représente le schéma équivalent du circuit de la figure 5. On peut y voir entre deux électrodes 16 et 17 un thyristor 20 correspondant à la partie gauche de la figure 5, une diode PIN 21 correspondant à la jonction 11/12 et une petite diode PN⁺ 22 correspondant à la jonction 11/7.

L'homme de l'art notera que la présente invention est susceptible de diverses variantes et peut notamment bénéficier des divers perfectionnements généralement apportés à la réalisation des diodes PIN qui ont été décrites ici seulement de façon schématique et rapide.

## Revendications

1. Diode PIN à faible surtension à la mise en conduction comprenant une région d'anode (4) de type P formée sur une première face d'un substrat (1) de type N faiblement dopé et une région de cathode (2) formée sur la deuxième face du substrat, comprenant sur une partie de la première face une région supplémentaire (7) de type N⁺ en contact avec la région d'anode pour former une jonction avec celle-ci, cette région supplémentaire étant connectée à la région de cathode.

2. Diode PIN selon la revendication 1, caractérisée en ce qu'elle est assemblée en une structure monolithique de façon tête-bêche avec un thyristor à déclenchement par avalanche.

## Patentansprüche

1. PIN-Diode mit geringer Überspannung beim Einschalten, umfassend einen Anodenbereich (4) des P-Typs, der auf einer ersten Seite eines Substrats (1) des N-Typs ausgebildet ist, welches schwach dotiert ist, und einen Kathodenbereich (2), der auf der zweiten Seite des Substrats ausgebildet ist, wobei auf einem Teil der ersten Seite ein Zusatzbereich (7) des N⁺-Typs ausgebildet ist, der mit dem Anodenbereich in Kontakt ist, um einen Übergang mit diesem zu bilden, wobei dieser Zusatzbereich mit dem Kathodenbereich verbunden ist.

2. PIN-Diode nach Anspruch 1, dadurch **gekennzeichnet**, daß sie in einer monolithischen Anordnung antiparallel mit einem Lavinendurchbruchstyristor verbunden ist.

## Claims

1. A PIN diode with a low voltage peak at the switching on comprising a P-type anode region (4) formed on a first surface of a low doped N-type substrate (1) and a cathode region (2) formed on the second surface of the substrate, comprising on a portion of the first surface an additional N⁺-type region (7) in contact with the anode region for forming a junction with the latter, said additional region being connected to the cathode region.

2. A PIN diode according to claim 1, characterized in that it is anti-parallel connected with an avalanche breakdown thyristor in a monolithic assembly.
